(19) **Europäisches Patentamt / European Patent Office / Office européen des brevets**

(11) **EP 3 399 231 A1**

(12) **EUROPEAN PATENT APPLICATION**
published in accordance with Art. 153(4) EPC

(43) Date of publication:
07.11.2018 Bulletin 2018/45

(21) Application number: 16881836.7

(22) Date of filing: 28.12.2016

(51) Int Cl.:
*F21V 23/00* (2015.01)  *F21S 2/00* (2016.01)
*F21S 8/04* (2006.01)  *F21V 19/00* (2006.01)
*F21V 29/503* (2015.01)  *F21V 29/70* (2015.01)
*F21Y 115/10* (2016.01)

(86) International application number:
**PCT/JP2016/089165**

(87) International publication number:
**WO 2017/115862 (06.07.2017 Gazette 2017/27)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: 28.12.2015 JP 2015256518
28.06.2016 JP 2016127468

(71) Applicant: **Irisohyama Inc.**
**Sendai-shi**
**Miyagi 9808510 (JP)**

(72) Inventors:
• **MIYAJIMA, Takahiro**
**Kakuda-shi**
**Miyagi 981-1596 (JP)**
• **SASAJIMA, Jun**
**Kakuda-shi**
**Miyagi 981-1596 (JP)**

(74) Representative: **Viering, Jentschura & Partner mbB**
**Patent- und Rechtsanwälte**
**Am Brauhaus 8**
**01099 Dresden (DE)**

(54) **LED LIGHTING DEVICE**

(57) A light-emitting diode lighting apparatus mountable onto a building material includes a substrate-less light-emitting module including a thin plate of a conductive wiring member corresponding to a wiring pattern, and at least one light-emitting diode directly mounted on the wiring member, a translucent cover covering the light-emitting module, and a support on which the translucent cover is attached. The wiring member is located at the translucent cover or the support.

[FIG. 3]

## Description

### Technical Field

The present invention relates to a light-emitting diode (LED) lighting apparatus, and more particularly, to an LED lighting apparatus including one or more LED chips as a light source.

### Background Art

A known LED lighting apparatus includes one or more LED chips as a light source. The LED lighting apparatus may include a wiring pattern, a metal base substrate having an insulating layer formed from a composite material, and multiple LED chips mounted on one surface of the metal base substrate (refer to, for example,

Patent Literature 1).

### Citation List

### Patent Literature

Patent Literature 1: Japanese Unexamined Patent Application Publication No. 2007-59930

### Summary of Invention

### Technical Problems

This LED lighting apparatus typically includes the metal base substrate having high heat dissipation to extend the lifetime of the LEDs. Although having a long lifetime, the LED lighting apparatus can be heavy, and expensive due to its multi-layered (complicated) structure.

In response to the above issue, one or more aspects of the present invention are directed to a substrate-less LED lighting apparatus that eliminates a base substrate and an insulating layer formed from a composite material, and thus is lightweight and inexpensive while maintaining high heat dissipation and a long lifetime.

### Solution to Problems

A light-emitting diode lighting apparatus according to one aspect of the present invention is mountable onto a building material. The apparatus includes a substrate-less light-emitting module including a thin plate of a conductive wiring member corresponding to a wiring pattern, and at least one light-emitting diode directly mounted on the wiring member, a translucent cover covering the light-emitting module, and a support on which the translucent cover is attached. The wiring member is located at the translucent cover or the support.

### Advantageous Effects of Invention

The LED lighting apparatus according to the above aspect of the present invention includes the thin plate of a conductive wiring member corresponding to a wiring pattern located at the translucent cover or the support. The LED lighting apparatus with this structure eliminates a metal base substrate and/or an insulating plate, and thus is lightweight and inexpensive while maintaining a long lifetime.

### Brief Description of Drawings

Fig. 1 is a perspective view of a ceiling-mountable straight tube lighting apparatus as an LED lighting apparatus.
Figs. 2A is a longitudinal cross-sectional view of the ceiling-mountable straight tube lighting apparatus as the LED lighting apparatus, and Fig 2B is a transverse cross-sectional view of the lighting apparatus.
Fig. 3A is a top view of a light-emitting module included in the LED lighting apparatus, and Fig. 3B is a bottom view of the light-emitting module.
Fig. 4 is a perspective view of the entire LED lighting apparatus attached to a ceiling mount.
Fig. 5 is a transverse cross-sectional view of the LED lighting apparatus.

Fig. 6A is a perspective view of a ceiling-mountable bulb lighting apparatus as an LED lighting apparatus, and Fig. 6B is a front view of a bulb that is partially cut away.

Fig. 7 is a cross-sectional view of a socket for a ceiling-mountable bulb lighting apparatus as an LED lighting apparatus.

Fig. 8 is a schematic diagram of a light-emitting module showing an example wiring member used in the LED lighting apparatus.

Fig. 9A is a perspective view of the entire LED lighting apparatus attached to a ceiling mount, and Fig. 9B is a front view of the LED lighting apparatus that is partially cut away.

Fig. 10 is a cross-sectional view of a ceiling light as an LED lighting apparatus.

Fig. 11A is a front view of wiring members in strips to be used in an LED lighting apparatus, where the wiring members are punched, and Fig. 11B is a front view of the wiring members on which LED chips have been mounted (partially).

Fig. 12 is a diagram describing mounting of LED chips onto the strip wiring members.

Fig. 13A is a front view of wiring members tilted as individual blocks joined to one another with bends, Fig. 13B is an enlarged front view of a bend portion in the wiring members, Fig. 13C is a front view of a bend portion that is raised, Fig. 13D is a front view of a bend portion that is bent, Fig. 13E is a diagram describing a wavy bend, and Fig. 13F is a diagram describing an angled bend.

Fig. 14A is a diagram describing connection of a wiring member to a power supply board, Fig. 14B is a diagram describing an interlocking joint, and Fig. 14C is a diagram describing a solder joint.

Fig. 15A is a front view of a wiring member with a fixing liquid applied for preventing misalignment of LED chips, Fig. 15B is a cross-sectional view of the wiring member in Fig. 15A showing its main components, Fig. 15C is a front view of the wiring member on which an LED chip has been mounted, and Fig. 15D is a cross-sectional view of the wiring member in Fig. 15C showing its main components.

Fig. 16A is a diagram describing a wiring member including lands, and showing an example arrangement of LED mount portions, Fig. 16B is a diagram describing the LED mount portions with a welding material applied, and Fig. 16C is a diagram describing the wiring member that has undergone resist processing in areas excluding the LED mount portions.

Fig. 17A is a front view of wiring members bent into a regular polygon, Fig. 17B is a front view of wiring members folded alternately, and Fig. 17C is a front view of wiring members bent into a cross.

Fig. 18A is a front view of a wiring member including a high-potential wiring member and a low-potential wiring member each having an extension, and Fig. 18B is a diagram describing the wiring member mounted on a bulb LED lamp.

Fig. 19A is a front view of wiring members that are arranged in series, and Fig. 19B is a diagram describing the wiring members used as a light source unit for a high ceiling-mountable lighting apparatus.

Fig. 20A is a front view of wiring members that are arranged in parallel, and Fig. 20B is a perspective view of a downlight including the wiring members in its reflector.

Fig. 21 is a diagram describing wiring members that are arranged in a cylinder in a streetlamp.

Fig. 22 is a diagram describing wiring members that are bent for connecting a single point to multiple points and arranged in a bulb LED lamp.

Fig. 23 is a perspective view of wiring members including conductive metal strips arranged in parallel.

Fig. 24A is a perspective view of an example light-emitting module used in an LED lighting apparatus, and Fig. 24B is an enlarged side view of a part of the light-emitting module.

Fig. 25 is a perspective view of the light-emitting module shown in Fig. 24A as a light-emitting module used in an LED lighting apparatus showing its rear surface.

Fig. 26 is a perspective view of an example light-emitting module used in an LED lighting apparatus.

Fig. 27 is a perspective view of the light-emitting module shown in Fig. 26 as an example light-emitting module used in an LED lighting apparatus showing its rear surface.

Fig. 28 is a perspective view of an example light-emitting module used in an LED lighting apparatus.

**Description of Embodiments**

An embodiment of the present invention will now be described with reference to the drawings.

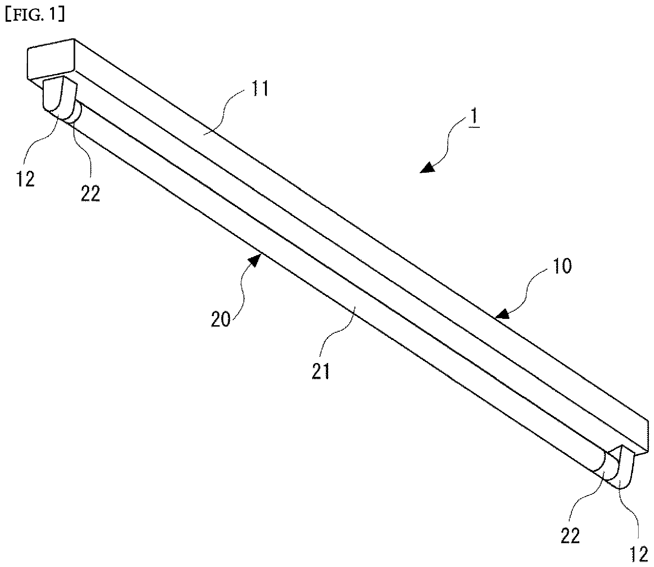

A light-emitting diode (LED) lighting apparatus 1 shown in Figs. 1 to 3B is a ceiling-mountable straight tube lighting apparatus.

As shown in Fig. 1, the LED lighting apparatus 1 includes a ceiling-mountable lighting fixture 10, which includes an enclosure 11 and a pair of sockets 12, and a straight tube LED lamp 20, which is attached to the lighting fixture 10 in a removable (replaceable) manner.

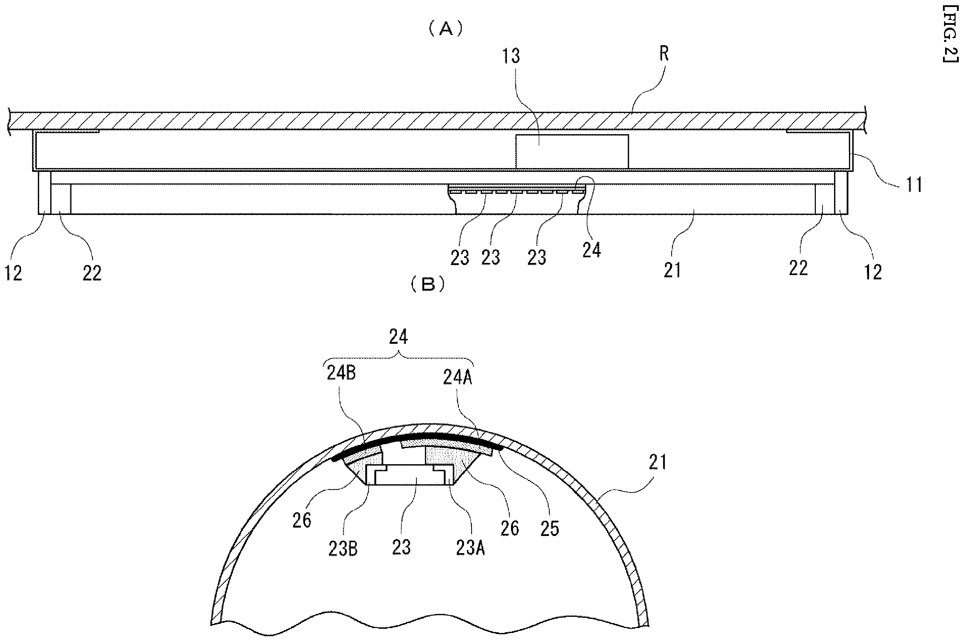

As shown in Fig. 2A, the lighting fixture 10 includes the enclosure 11 fixed to a ceiling R of a building with, for example, screws. The enclosure 11 is selectable from various types with different specifications to allow the number and lengths of LED lamps 20 to be attached to the sockets 12 to provide brightness based on user's demand. In the present embodiment, the enclosure 11 includes a thin metal plate with an opening in its upper surface (surface to face the ceiling R), and accommodates a power supply unit 13 connected to a power cable (not shown), which is routed inside the building.

The lighting fixture 10 includes the power supply unit 13 incorporating a power supply circuit, which includes electronic components such as an AC/DC converter and an overcurrent protection element. The lighting fixture 10 with this structure can use the LED lamp 20 including LED chips as a light source.

As shown in Fig. 2B, the LED lamp 20 includes, for example, a translucent cover 21 formed from a long glass tube, and bases 22 at both ends of the translucent cover 21. The bases 22 are engaged with the sockets 12. The translucent cover 21 accommodates at least one LED chip 23, and a wiring member 24 having the at least one LED chip 23 directly mounted on its surface. The wiring member 24, which is formed from a conductive material, corresponds to a wiring pattern. The LED chips (or chip) 23, which are each quadrate (e.g., rectangular), and the wiring member 24, on which the LED chips 23 are mounted directly, construct a light-emitting module in the claims. The bases 22 also serve as supports for the two ends of the translucent cover 21.

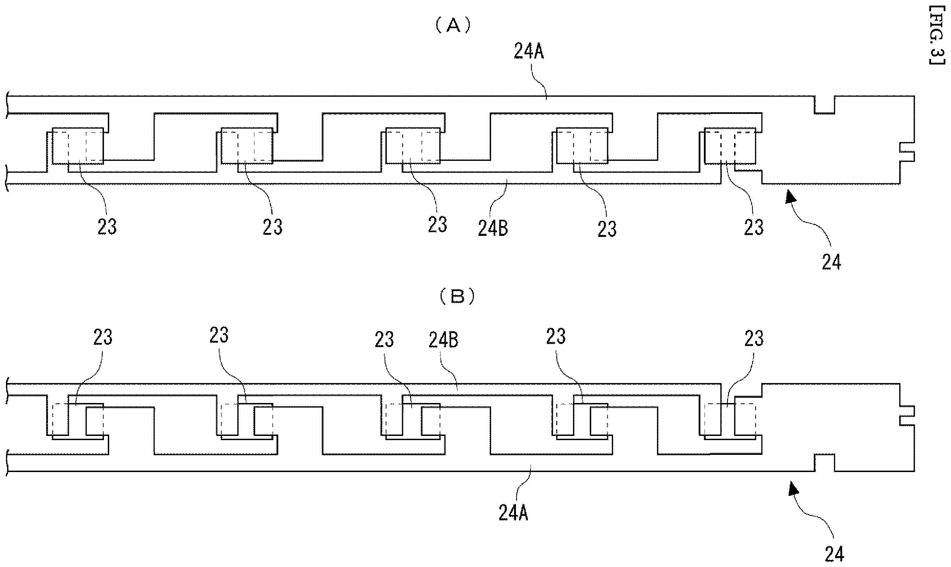

As shown in Figs. 3A and 3B, the wiring member 24 in the present embodiment has the LED chips 23 arranged in parallel. The wiring member 24 includes a high-potential wiring member 24A and a low-potential wiring member 24B. The wiring member 24 is a thin conductive plate having a two-dimensional wiring pattern without including substrate (printed wiring board). In other words, the wiring member 24 equates to a thin copper wiring pattern removed from a typical printed wiring board (e.g., a glass epoxy substrate). The wiring member 24 may be prepared by, for example, laser-cutting, etching, or punching a metal plate. The rear surface of the wiring member 24, on which no LED chip 23 is fixed by, for example, soldering, is bonded to the inner surface of the translucent cover 21, which is a glass tube. As shown in Fig. 2B, the wiring member 24 is directly fixed to the inner surface of the translucent cover 21 with an adhesive 25, which is insulating and resistant to heat generated while the LED chips 23 are turned on. This structure allows electricity to be supplied from the power supply unit 13 to the wiring member 24 to turn on the LED chips 23. In Fig. 2B, the high-potential wiring member 24A in the wiring member 24 is connected and fixed to an anode 23A of each LED chip 23 with solder 26, whereas the low-potential wiring member 24B is connected and fixed to a cathode 23B of each LED chip 23 with solder 26.

The adhesive may be, for example, an organopolysiloxane-based silicone adhesive, or an epoxy resin-based adhesive, which are insulating and resistant to heat generated while the LED chips 23 are turned on. The wiring member 24 may be formed from a nickel-plated iron plate having a thickness of about 0.2 to 0.6 mm or a copper plate having a thickness of about 0.3 to 1.0 mm. The wiring member 24 may also have notches as appropriate for easy alignment of the LED chips 23, soldering with no excess solder flow, and reducing stress after soldering. Similarly, the wiring member 24 may be embossed to avoid excess solder flow and to increase strength. Further, the high-potential wiring member 24A and the low-potential wiring member 24B may be joined together with an adhesive or a resin applied between them, or may be potted together. This strengthens the wiring member 24, protects the solder joints between the wiring member 24 and the LED chips 23, achieves reliable insulation, and enables the wiring member 24 along lens shapes. The adhesive may be replaced by an adhesive sheet.

In the present embodiment as described above, the translucent cover 21 contains the light-emitting module including at least one LED chip 23 and the wiring member 24 formed from a conductive material into a wiring pattern, on which the LED chips (or chip) 23 are directly mounted. The LED lamp 20 with this structure includes no printed wiring board that is expensive and heavy and uses a large space for wiring, and thus is lightweight and inexpensive while maintaining a long lifetime.

Although multiple LED chips 23 are arranged in parallel electrically in the above embodiment, the LED chips 23 may be arranged in series electrically.

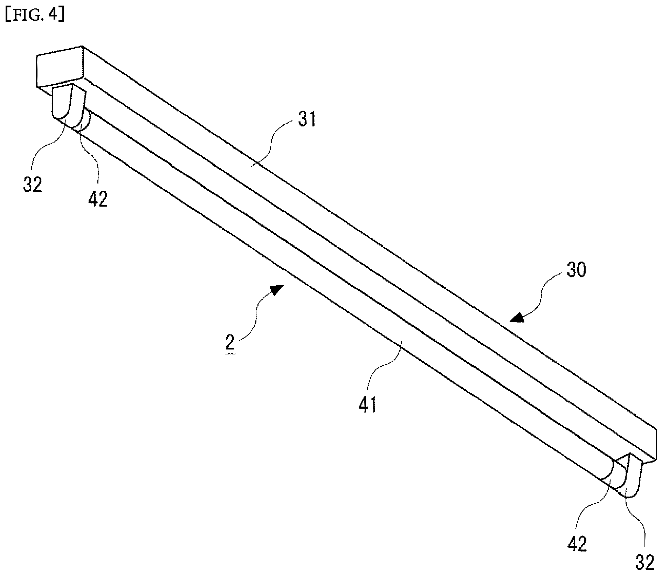

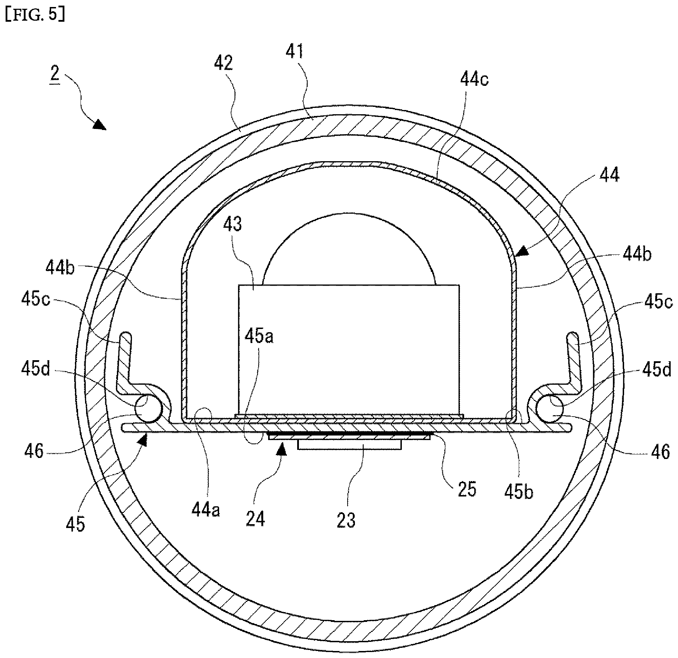

Figs. 4 and 5 show an LED lighting apparatus 2 attached to a ceiling-mountable straight tube lighting fixture 30.

More specifically, although the LED lighting apparatus 1 according to the above embodiment includes the lighting fixture 10 and the straight tube LED lamp 20, the LED lighting apparatus 2 according to the present embodiment contains a power supply circuit and can thus replace a fluorescent tube in an existing straight-tube lighting apparatus used in a building.

As shown in Fig. 4, the LED lighting apparatus 2 is attached to the ceiling-mountable lighting fixture 30 in a removable (replaceable) manner. The ceiling-mountable lighting fixture 30 includes an enclosure 31 and a pair of sockets 32.

The LED lighting apparatus 2 includes a translucent cover 41, which is a long glass tube, and bases 42, which are arranged at both ends of the translucent cover 41. With the bases 42 engaged with the sockets 32 , the LED lighting apparatus 2 is held by the lighting fixture 30. The bases 42 also serve as supports for the two ends of the translucent cover 41.

As shown in Fig. 5, the LED lighting apparatus 2 includes the translucent cover 41 containing a wiring member 24, on which multiple LED chips 23 are mounted, a power supply unit 43, which includes a power supply circuit for supplying electricity to the wiring member 24, a tubular cover 44, which covers the power supply unit 43, and a long and flat plate heat sink 45, which separates and supports the wiring member 24 and the power supply unit 43 along the axis of the tube. In the present embodiment, the translucent cover 41 (or the tubular cover 44) corresponds to a casing in the claims, and the heat sink 45 corresponds to a support in the claims.

The translucent cover 41 is tubular, and has at least an integrated structure including a light diffusion layer, a translucent glass layer, and a translucent protection layer in the stated order from the inner layer. The entire translucent cover 41 functions as a glass translucent unit that transmits the luminous flux emitted from the LED chips 23. The light diffusion layer is, for example, a film of a white silicone coating applied to the entire inner surface of the glass layer. The light diffusion layer has a thickness of about 0.08 mm. The glass layer is a colorless transparent tube formed from, for example, borosilicate glass. The glass layer has a thickness of about 0.75 mm. The protection layer is, for example, a film of a heat-shrinkable resin, such as polyethylene terephthalate (PET) resin. The protection layer after shrunk by heat has a thickness of about 0.08 mm.

The power supply unit 43 includes a power supply circuit including electronic components such as an AC/DC converter or an overcurrent protection element. The LED lighting apparatus 2 can thus include the LED chips 23 as a light source.

The tubular cover 44 includes a bottom wall 44a extending inward from the base 42 that receives electricity, a pair of vertical walls 44b rising from the longitudinal edges of the bottom wall 44a, and an upper wall 44c joining the upper edges of the vertical walls 44b. The tubular cover 44 opens at its both ends.

The heat sink 45 has a lower surface 45a, to which the wiring member 24 is fixed with an adhesive, and an upper surface 45b, which is opposite to the lower surface 45a and supports the power supply unit 43. The heat sink 45 integrally includes walls 45c rising from the upper surface 45b, and grooves 45d extending between the walls 45c and the upper surface 45b along the axis of the tube.

The walls 45c rise from the edges of the heat sink 45 extending along a tube axis P, and bend at their lower ends to have U-shaped cross-sections, thus forming the grooves 45d integrally. The grooves 45d longitudinally extend across the heat sink 45 along the axis of the tube. In other words, the grooves 45d extend across the entire length of the heat sink 45. The grooves 45d receive support screws 46 included in holders (not shown) that allow the bases 42 to support the heat sink 45. The grooves 45d may have internal threads, or may use plastic deformation caused by a different hardness of a material (e.g., aluminum) for receiving the support screws 46.

The heat sink 45 with this structure can be formed from an extruded metal material, such as aluminum.

The extruded heat sink 45 may undergo alumite treatment for more effective heat dissipation. A reflective sheet that also serves as an insulator may be arranged between the heat sink 45 and the wiring member 24 to increase the lighting efficiency. The reflective sheet is thinner than a common printed wiring board, and thus has a lower thermal resistance. The reflective sheet allows efficient conduction of heat from the LEDs to the heat sink 45.

The bend portions in the walls 45c along the longitudinal edges of the heat sink 45 adjacent to the flat plate increase the torsional strength of the heat sink 45.

More specifically, the long heat sink 45 may have torsion or flexure during installation. For example, although such torsion or flexure may not affect the installation while joining one of the bases 42 and the holder, it may cause misalignment between the other base 42 and the other holder during installation. The heat sink 45 without having a closed cross-section achieves high stiffness, and therefore is lightweight. The structure with less torsion and flexure allows easy installation of the heat sink 45 and other parts, and also increases the inner space of the tube for accommodating connectors or electronic components (not shown).

In this structure as well, the translucent cover 41 contains a light-emitting module including at least one LED chip 23 and the wiring member 24 formed from a conductive material into a wiring pattern, on which the LED chips (or chip) 23 are directly mounted.

The wiring member 24 has a rear surface for fixing to the lower surface 45a of the heat sink 45. The LED lighting apparatus 2 with this structure includes no printed wiring board that is expensive and heavy and uses a more space for wiring, and thus is lightweight and inexpensive while maintaining a long lifetime.

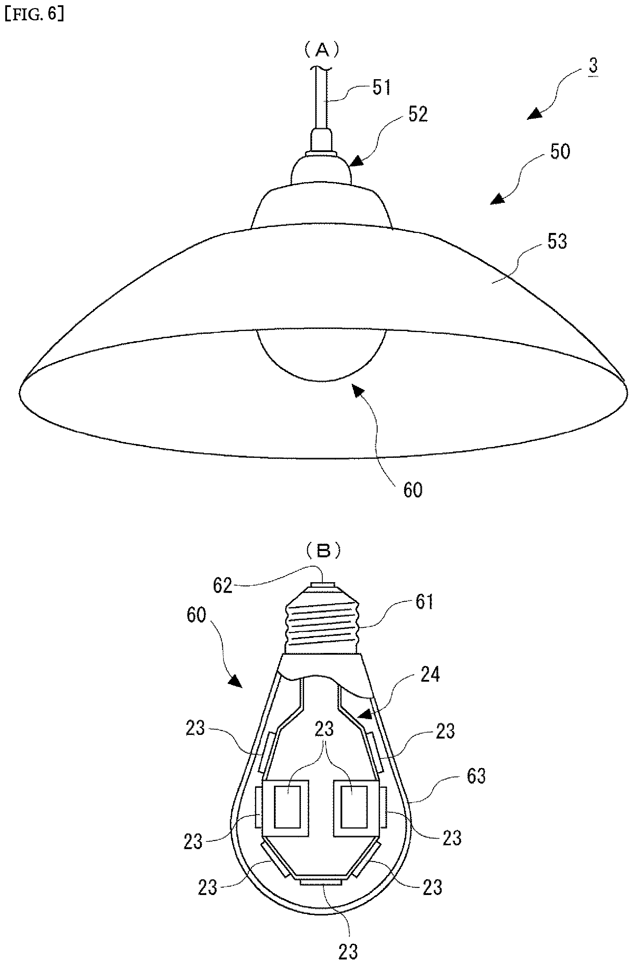

Figs. 6A to 8 show an LED lighting apparatus 3 as a ceiling-mountable bulb lighting apparatus.

As shown in Figs. 6A and 6B, the LED lighting apparatus 3 includes a pendant lighting fixture 50 hanging from a ceiling, and a bulb LED lamp 60 attached to the lighting fixture 50 in a removable (replaceable) manner.

The lighting fixture 50 includes a cord 51 hanging from a ceiling, a socket 52 attached to the lower end of the cord 51 to hold the LED lamp 60 in a removable manner for supplying electricity to the LED lamp 60, and a lampshade 53 covering the LED lamp 60.

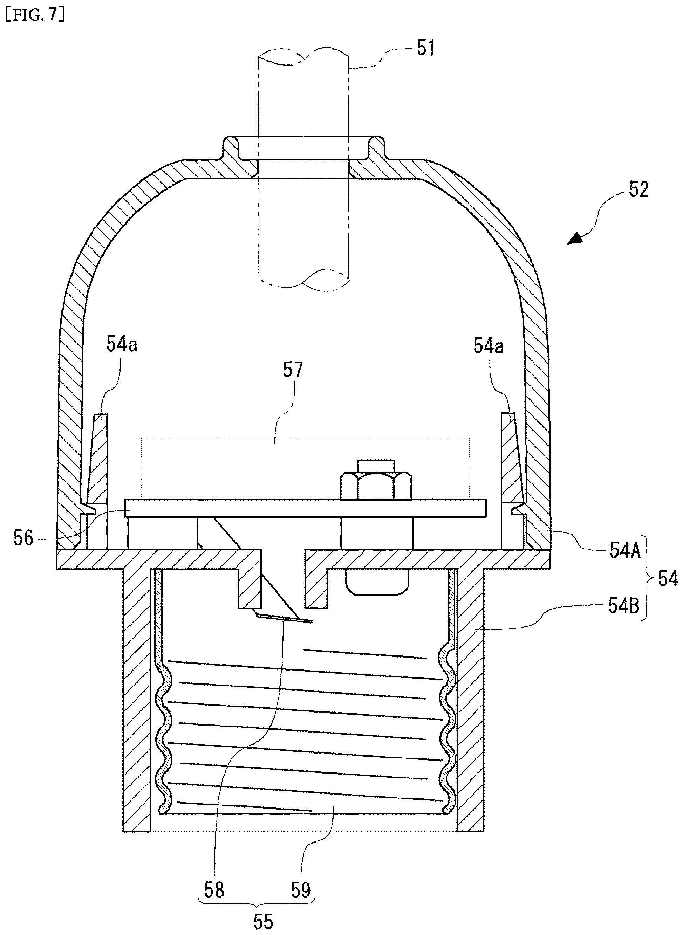

As shown in Fig. 7, the socket 52 includes a cover 54, a receptacle 55, which is engaged with a base 61 (refer to Fig. 6B) of the LED lamp 60, a base member 56, which is arranged behind the receptacle 55, and a power supply unit 57, which is mounted on the base member 56 to receive electricity supplied from an external power source through the cord 51. Thus, the socket 52 corresponds to a casing in the claims.

The cover 54 includes a base cover 54A, which supports the base member 56, and a socket cover 54B, which is held by the base cover 54A with lance-shaped engagement tabs 54a that latch onto the base cover 54A.

The receptacle 55 includes an output terminal 58, which is held by the base member 56 and having one end connected to the high potential end of the power supply unit 57 and the other end exposed inside the socket cover 54B, and a receptacle part 59, which is held by the socket cover 54B and connected to the low potential end of the power supply unit 57.

The LED lamp 60 includes a base 61 with a contact 62, which is insulated and comes in contact with the output terminal 58, a glass bulb (globe) 63 attached to the base 61, one or more wiring members 24, which are bent into a predetermined shape along the inner surface of the glass bulb 63, and multiple LED chips 23 soldered to the wiring members 24.

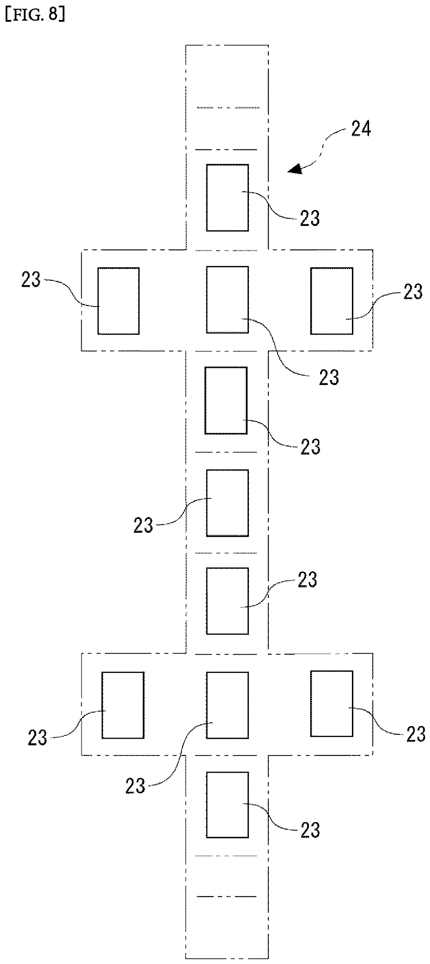

As shown in Fig. 8, the wiring member 24 in the present embodiment has the LED chips 23 arranged in parallel, and includes a high-potential wiring member (not shown) and a low-potential wiring member (not shown) in the same manner as described with reference to Fig. 3. When expanded, the wiring member 24 has substantially the shape of a double cross, and has one end electrically connected to the contact 62 and the other end to the base 61, and is bent into a three-dimensional shape along the inner surface of the glass bulb 63 as shown in Fig. 6B.

In this structure as well, the glass bulb 63 contains a light-emitting module including at least one LED chip 23 and the wiring member 24 formed from a conductive material into a wiring pattern, on which the LED chips (or chip) 23 are directly mounted.

The wiring member 24 is bent into a three-dimensional shape to allow the LED chips 23 to be located at the inside of the glass bulb 63. The LED lighting apparatus 2 with this structure includes no printed wiring board that is expensive and heavy and uses a more space for wiring, and thus is lightweight and inexpensive while maintaining a long lifetime.

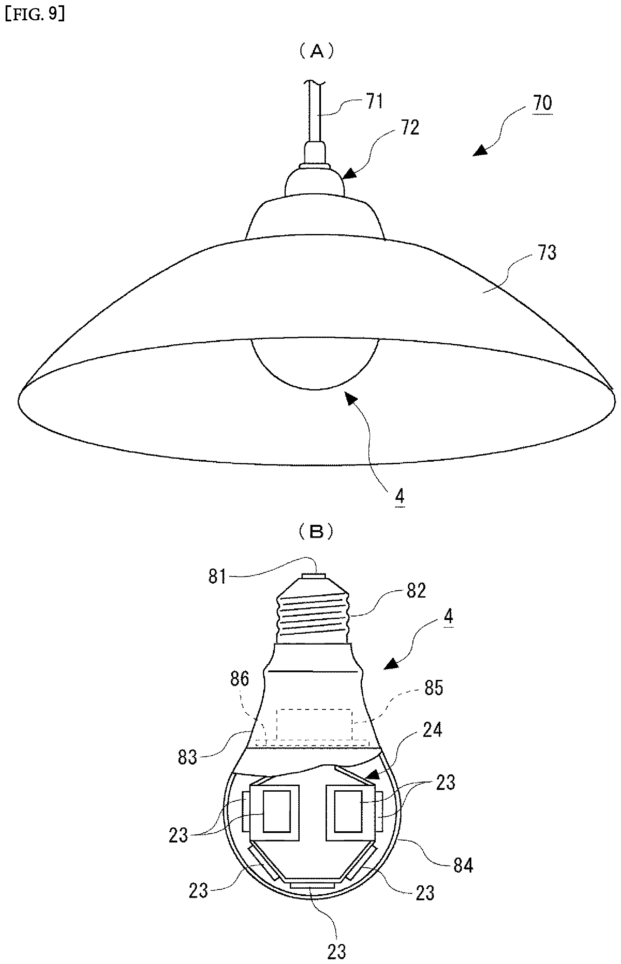

Figs. 9A and 9B show an LED lighting apparatus 4 attached to a ceiling-mountable bulb lighting fixture 70.

More specifically, although the LED lighting apparatus 3 according to the above embodiment includes the lighting fixture 50 and the bulb LED lamp 60, the LED lighting apparatus 4 according to the present embodiment contains a power supply circuit and can thus replace a light bulb in an existing bulb lighting apparatus used in a building.

Figs. 9A and 9B show the bulb LED lighting apparatus 4 attached in a removable (replaceable) manner to the pendant lighting fixture 70 hanging from a ceiling.

The lighting fixture 70 includes a cord 71 hanging from a ceiling, a socket 72 mounted on the lower end of the cord 71 to hold the LED lighting apparatus 4 in a removable manner for supplying electricity, and a lampshade 73 covering the LED lighting apparatus 4.

The LED lighting apparatus 4 includes a base 82 with a contact 81, which is insulated and comes in contact with an output terminal (not shown) of the socket 72, a tubular cover 83 mounted on the base 82, and a glass bulb (globe) 84 mounted on the cover 83.

The LED lighting apparatus 4 includes multiple wiring members 24, which are bent into a predetermined shape along the inner surface of the glass bulb 84, and multiple LED chips 23 soldered to the wiring members 24. The LED lighting apparatus 4 further includes the socket 72 containing a power supply unit 85 including a power supply circuit for supplying electricity to the wiring members 24, and a disk-shaped heat sink 86 that separates the wiring members 24 and the power supply unit 85 in a vertical direction (during use) and supports the wiring members 24 and the power supply unit 85. The cover 83 serves as a casing for containing the power supply unit 85. The cover 83 serves as a support for attaching the glass bulb (translucent cover) 84 to the base 82.

The wiring members 24 in the present embodiment each have the LED chips 23 arranged in parallel, and each include a high-potential wiring member (not shown) and a low-potential wiring member (not shown) in the same manner as described in Fig. 3. The wiring members 24, which have substantially the shape of a double cross when expanded, have one end electrically connected to the contact 81 and the other end connected to the base 82. The wiring members 24 are bent into a three-dimensional shape along the inner surface of the glass bulb 84 in the same manner as described with reference to Fig. 6B. This structure provides a wider light distribution angle (e.g., an angle of about 300°, whereas an existing LED lamp has a light distribution angle of 120°) by bending the soldered wiring members 24 into a three-dimensional shape. The wiring members 24 may be bent into a three-dimensional structure to have higher strength and higher heat dissipation.

In the present embodiment, the glass bulb 84 contains a light-emitting module including at least one LED chip 23 and the wiring members 24 formed from a conductive material into a wiring pattern, on which the LED chips (or chip) 23 are directly mounted. Thus, the bulb LED lighting apparatus 4 includes, along the axis of the base 82, the base 82, the cover (casing and support) 83, the light-emitting module, and the glass bulb (translucent cover) 84 in the stated order.

The wiring members 24 are bent into a three-dimensional shape to allow the LED chips 23 to be located inside the glass bulb 84. LED lighting apparatus 4 with this structure includes no printed wiring board that is expensive and heavy and uses a more space for wiring, and thus is lightweight and inexpensive while maintaining a long lifetime.

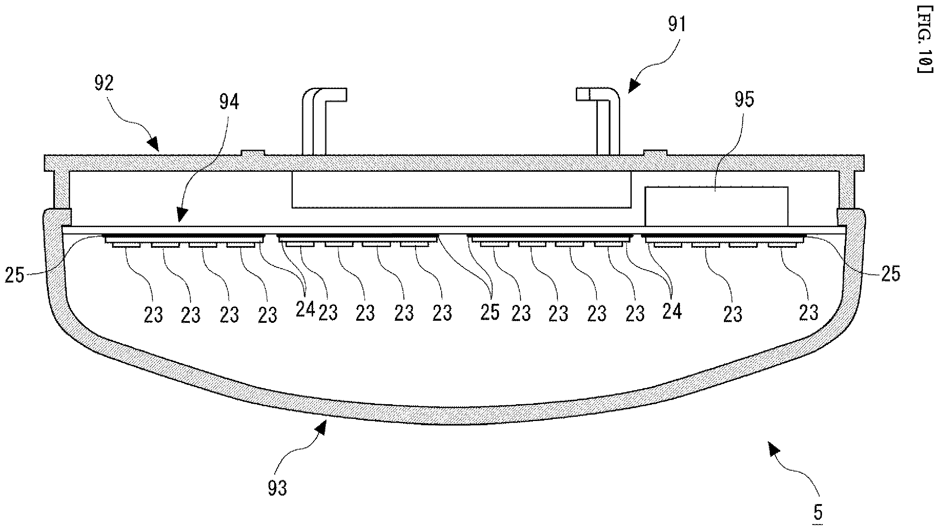

Fig. 10 shows an LED lighting apparatus 5 as a ceiling light.

As shown in Fig. 10, the LED lighting apparatus 5 is a ceiling light including a hooking ceiling plug 91, which is mountable on a ceiling, a base member 92, to which the hooking ceiling plug 91 is fixed, a translucent cover (shade) 93, which is mounted on the base member 92, a heat sink 94, which is fixed to the base member 92 to support the translucent cover 93, and a power supply unit 95, which is fixed to the upper surface of the heat sink 94 to receive electricity supplied from an external source through the hooking ceiling plug 91.

The heat sink 94 includes, on its lower surface, multiple wiring members 24 arranged in a predetermined shape as a whole, such as rectangular or in the shape of a fan, and multiple LED chips 23 welded onto the wiring members 24.

The wiring members 24 according to the present embodiment each have the LED chips 23 arranged in parallel, and each include a high-potential wiring member (not shown) and a low-potential wiring member (not shown) in the same manner as described in Fig. 3. The wiring members 24 are fixed to the heat sink 94 with an adhesive to receive electricity supplied from the power supply unit 95.

In this structure as well, the translucent cover 93 contains a light-emitting module including at least one LED chip 23 and the wiring members 24 formed from a conductive material into a wiring pattern, on which the LED chips (or chip) 23 are directly mounted.

The LED lighting apparatus 5 with this structure includes no printed wiring board that is expensive and heavy and uses a more space for wiring, and thus is lightweight and inexpensive while maintaining a long lifetime.

The wiring member 24 may be formed by stamping (punching) in which a part to be a high-potential wiring member and a part to be a low-potential wiring member are formed integrally from a thin conductive metal plate. The high-potential part and the low-potential part may then be split into individual components after LED chips 23 are fixed to form a light-emitting module. This wiring member 24 is thus usable for various LED lighting apparatuses.

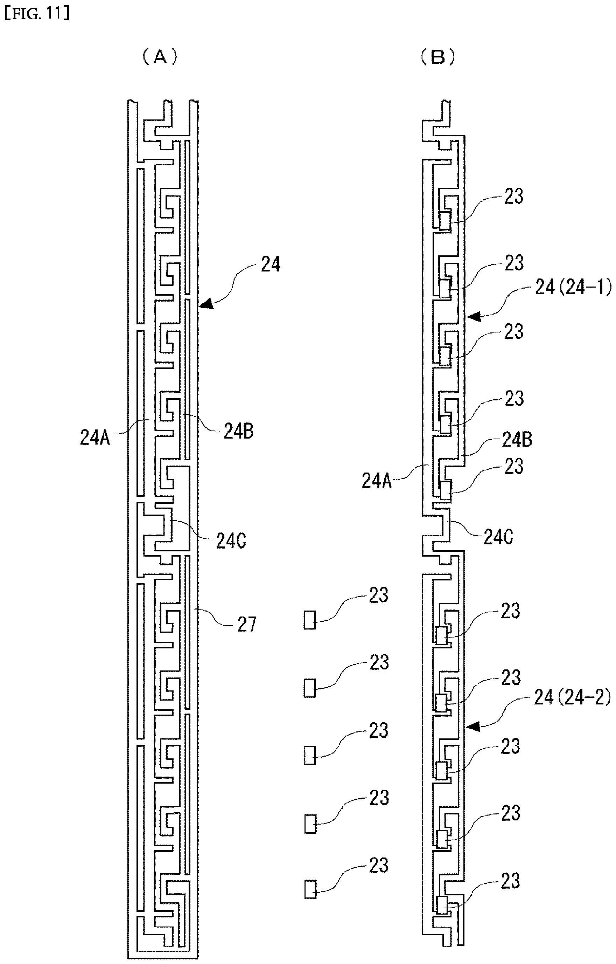

For example, the ceiling-mountable straight tube lighting apparatus as the LED lighting apparatus described above may include wiring members 24 that are continuously aligned on a straight line. In this case, high-potential wiring members 24A and low-potential wiring members 24B are electrically insulated for supplying electricity to LED chips 23 mounted on these members. However, the preceding manufacturing processes such as punching of a thin metal plate may include the high-potential wiring members 24A and the low-potential wiring members 24B connected with each other with a bridge 27 as shown in Fig. 11A.

As shown in Fig. 11B, the high-potential wiring members 24A and the low-potential wiring members 24b are subsequently separated by removing the bridge 27 when the LED chips 23 are mounted. The wiring members 24 are punched to remove unnecessary portions before the bridge 27 is removed. This process thus corresponds to punching out the unnecessary portions, which is opposite to the typical punching processes such as blanking, in which products are punched out.

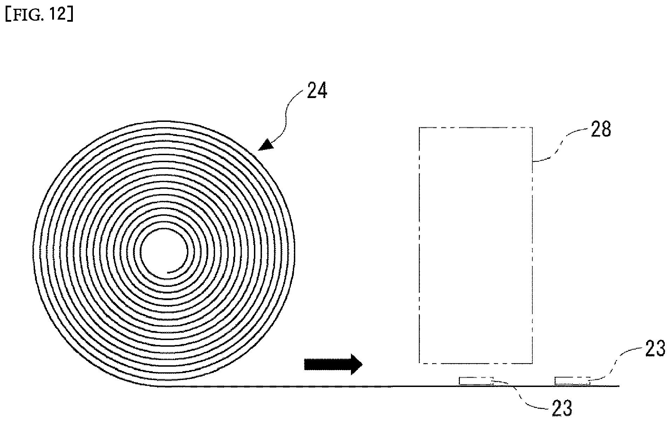

As shown in Fig. 12, the high-potential wiring members 24A and the low-potential wiring members 24B connected to each other with the bridge 27 may be wound in a roll, thus allowing LED chips 23 to be mountable using a mounter 28 on an assembly line.

As shown in Figs. 11A to 12, the wiring members 24 may be arranged in multiple blocks (24-1 or 24-2) each including, for example, five LED chips 23 as shown in Fig. 11B. The blocks are connected to one another with bend portions 24C. Although the high-potential wiring members 24A are joined with the bend portion 24C in Figs. 11A and 11B, the low-potential wiring members 24B may be joined, or high-potential wiring members 24A and low-potential wiring members 24B may be joined alternately.

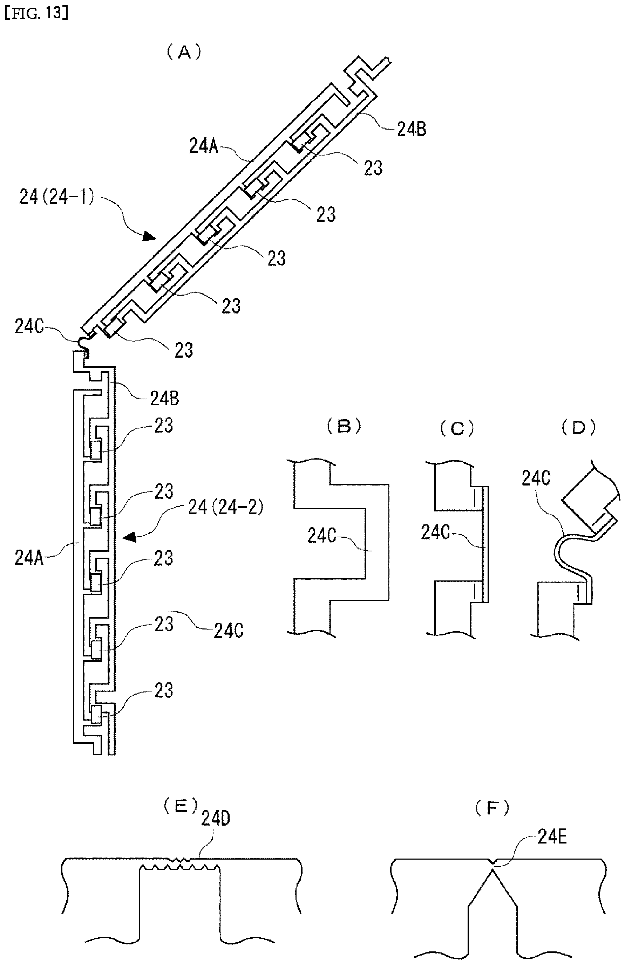

Figs. 13A to 13F show blocks of wiring members that are bent with bend portions 24C described above. As shown in Fig. 13A, the blocks (24-1 and 24-2) of the wiring members 24 may be bent at the bend portion 24C as appropriate. In this case, the wiring members 24 are formed from a single metal plate, and thus have the high-potential wiring members 24A, the low-potential wiring members 24B, and the bend portions 24C located in the same plane. In this case, directly bending the bend portion 24C can cause torsion or misalignment of adjacent blocks (24-1 and 24-2).

In response to this, the bend portion 24C as a flat plate shown in Fig. 13B is first raised in the manner shown in Fig. 13C, and is then bent the blocks (24-1 and 24-2) in an intended direction. In the case of limited space for raising the bend portion 24C, the wiring members 24 may have a wavy bend portion 24D (Fig. 13E) or an angled bend portion 24E (Fig. 13F) with narrow notches to allow the bend portions 24D and 24E to be in the same plane as the blocks (24-1 and 24-2).

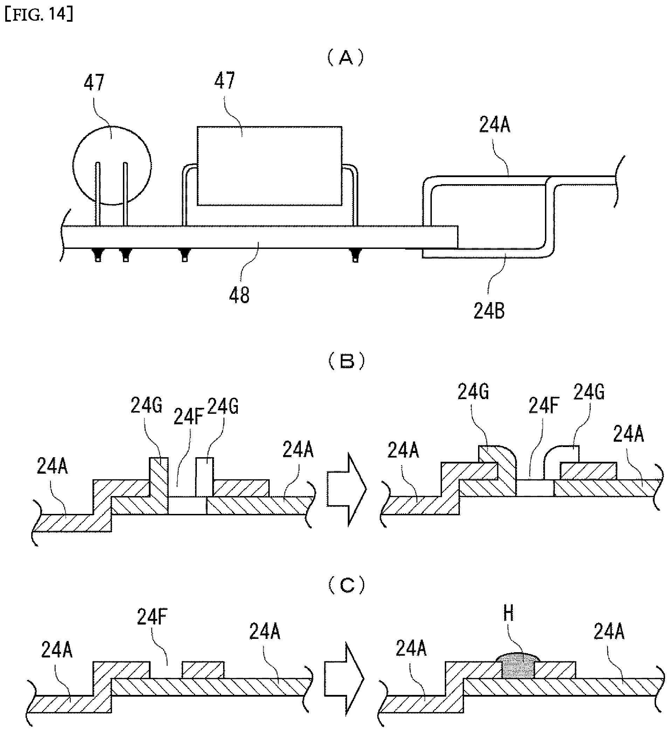

As shown in Fig. 14A, a high-potential wiring member 24A and a low-potential wiring member 24B may have their ends bent in a predetermined shape for direct connection to a power supply board 48 (by, for example, welding) on which electronic components 47 or the power supply unit 43 (not shown in Fig. 14A) are mounted. This structure eliminates lead wiring members for connecting a wiring member 24 to the power supply board 48, thus reducing the number of components. The wiring member 24 can be integral with the power supply board 48, which is relatively heavy, with high strength. This facilitates the mounting onto a lighting apparatus.

As shown in Fig. 14B, either the high-potential wiring member 24A or the low-potential wiring member 24B may have an end with a step to form a connection hole 24F, and the other one of the high-potential wiring member 24A and the low-potential wiring member 24B may have an end with a cut-and-bent engaging piece 24G. The engaging piece 24G may then be engaged with the connection hole 24F to join the ends of the blocks.

As shown in Fig. 14C, either the high-potential wiring member 24A or the low-potential wiring member 24B may have an end with a step to provide a connection hole 24F, to which an end of the other one of the high-potential wiring member 24A and the low-potential wiring member 24B may be joined with solder H.

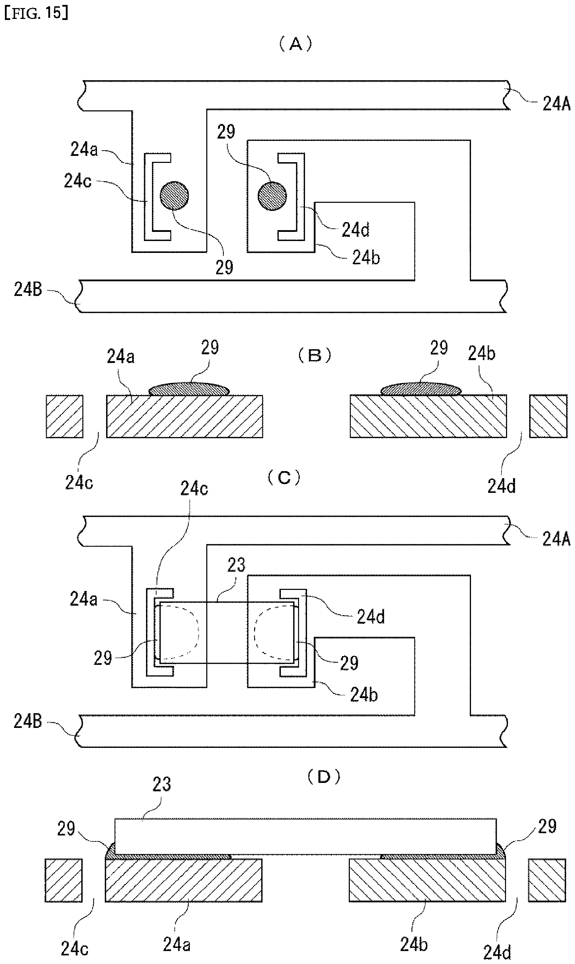

The LED chips 23 are fixed with solder to the high-potential wiring members 24A and the low-potential wiring members 24B. More specifically, as shown in Figs. 15A to 15D, the high-potential wiring member 24A and the low-potential wiring member 24B include mount portions 24a and 24b facing each other, across which each LED chip 23 is to be mounted.

As shown in Figs. 15A and 15B, solder cream 29 is applied to the mount portions 24a and 24b, and the LED chip 23 is then mounted on the mount portions 24a and 24b as shown in Figs. 15C and 15D. Subsequently, the solder 29 is melted in, for example, a reflow oven to complete the mounting of the LED chip 23 onto the mount portions 24a and 24b.

The molten solder 29 may flow to move the LED chip 23. The mount portions 24a and 24b may include grooves 24c and 24d that are punched as through-holes at positions outward from the mounting position of the LED chip 23. This structure allows the solder 29 to have surface tension and prevents the solder 29 from flowing out of the grooves, retaining the solder 29 at the intended position without unexpected movement. The grooves 24c and 24d may be replaced by blind holes or may be formed by dimpling.

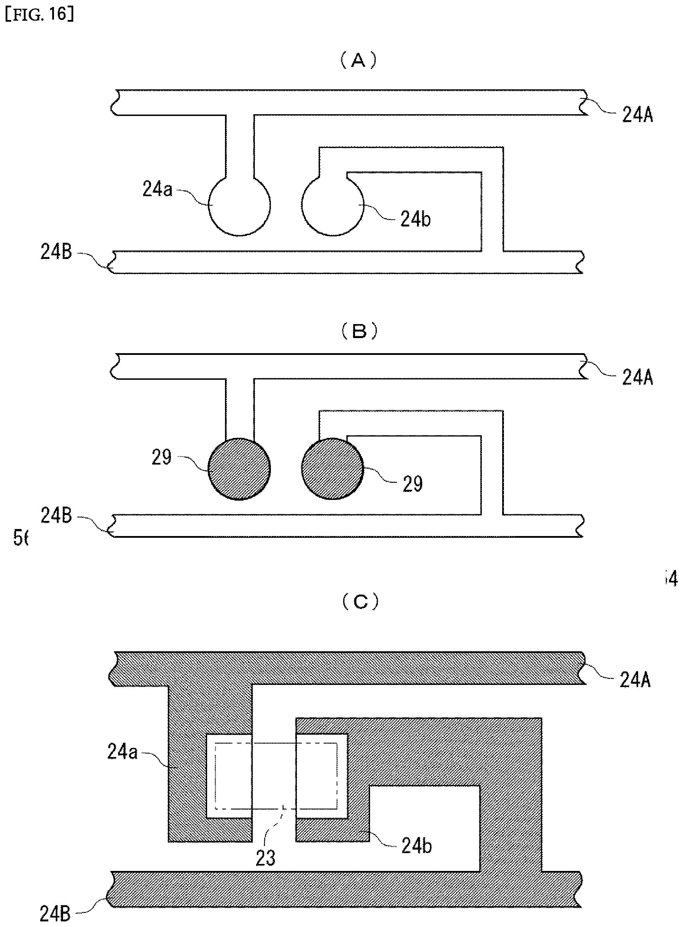

The mount portions 24a and 24b may be, for example, lands as shown in Fig. 16A. In this case, as shown in Fig. 16B, the molten solder 29 resides within the lands that serve as the mount portions 24a and 24b, and can solder the LED chip 23 without misalignment.

As shown in Fig. 16C, solder resist paint or heat-resistant paint may be applied to form a masking film excluding areas to be soldered. This allows the molten solder 29 to reside within each land.

Soldering using the solder 29 (solder 26) may be replaced by fixing such as welding, electrically conductive bonding, and crimping that achieves electrical connection. The wiring members 24 may include an iron plate as its base, which costs less than a copper plate. The wiring members 24 having the LED chips 23 mounted on them may be covered with a transparent resin (semitransparent resin including a colored resin and a colorless resin) or may have a diffusing lens or various prisms.

As described above, the wiring members 24 include the high-potential wiring members 24A and the low-potential wiring members 24B that can be easily processed by punching to function as simple lead wiring members. This eliminates a bus bar (or a bus), and increases the design flexibility. The LED chips 23 may temporarily be fixed using an adhesive before fixed with the solder 29.

When an insulating adhesive is used, the solder 29 maintains electrical connection between the wiring members 24 and the LED chips 23. Although the wiring members 24 are processed by punching for productivity and mass productivity, the wiring members 24 may also be processed by laser cutting or etching. The wiring members may undergo surface treatment, for example, applying a high-reflectance resist with high thermal radiation characteristics to increase thermal radiation and light reflection.

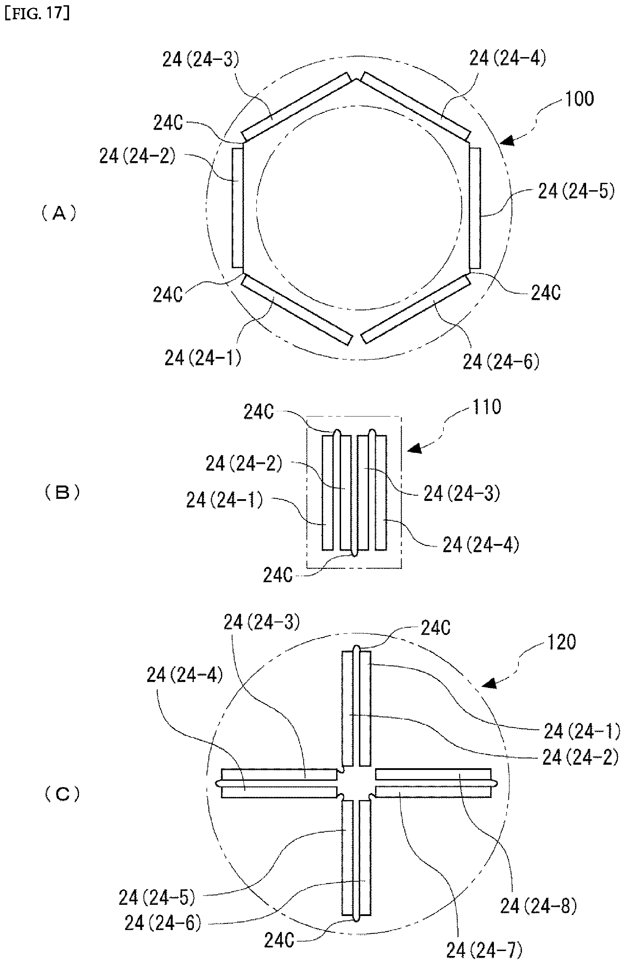

As shown in Fig. 17A, the wiring members 24 may be bent in blocks (24-1 to 24-6) to form a regular polygon (a substantial hexagon) for use in a tubular LED lamp 100.

As shown in Fig. 17B, the wiring members 24 may be folded alternately in blocks (24-1 to 24-4) for use in an LED lamp 110.

As shown in Fig. 17C, the wiring members 24 may be bent in blocks (24-1 to 24-8) to form a cross for use in a ceiling light LED lamp 120.

As described above, the wiring members 24 may be bent easily along the shape of a product. The wiring members 24 may be curved in blocks. The punched wiring members 24 may have their residual portions that may not be removed as appropriate, and may be bent into fins to provide heat dissipation while maintaining strength.

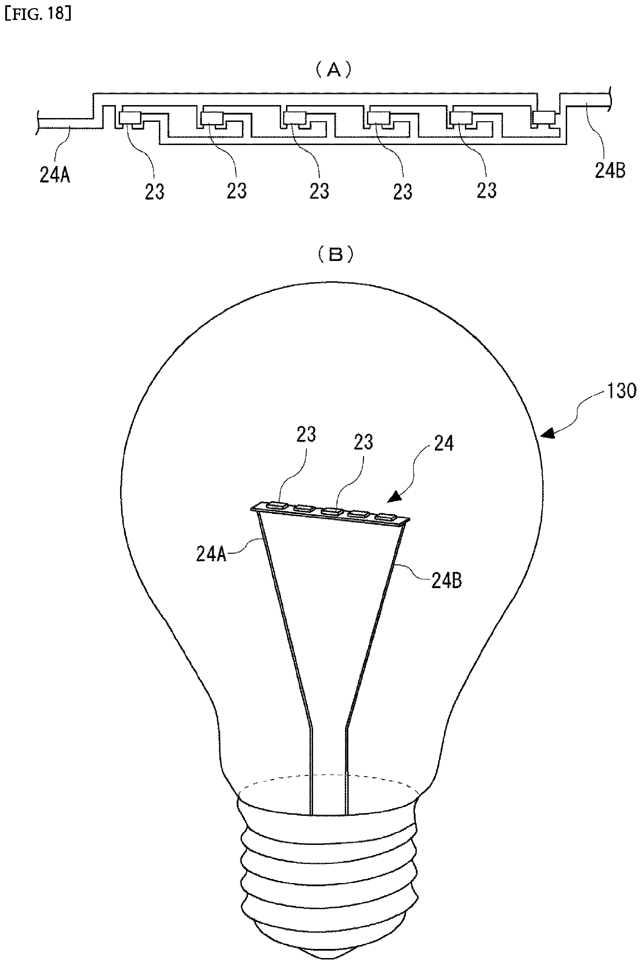

As shown in Fig. 18A, a wiring member 24 may include a high-potential wiring member 24A and a low-potential wiring member 24B with extensions at their ends. The wiring member 24 having the LED chips 23 mounted on it may then be used in an LED lamp 130 to replace a filament lamp as shown in Fig. 18B. In this case, the ends of the high-potential wiring member 24A and the low-potential wiring member 24B may be used as lead wiring members at the same positions as in the filament.

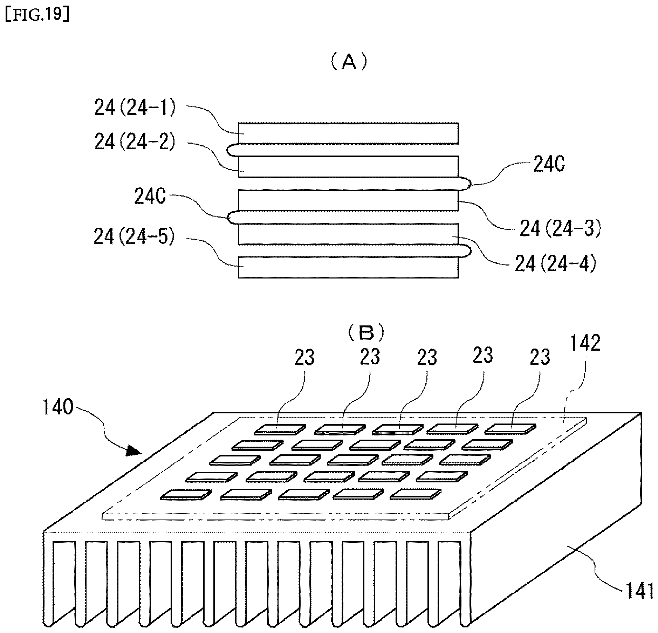

The wiring members 24 may be arranged in series and folded alternately in blocks (24-1 to 24-5) as shown in Fig. 19A. These wiring members 24 may be used as a light source unit 140 in a high ceiling-mountable lighting apparatus (not shown) as shown in Fig. 19B.

The wiring members 24 may be formed from a metal with high thermal conductivity. This structure allows the LEDs, which are directly soldered to such wiring members, to have the optimum thermal characteristics. This is achieved simply by using a silicone land 142 having high insulation between the wiring members 24 and a heat sink 141. These wiring members 24 are used in the high ceiling-mountable lighting apparatus, which herein refers to a lighting apparatus used in a building with a ceiling height of 6 m or higher, such as a factory or a gymnasium to emit a total luminous flux of 10,000 lm or more. The wiring members 24 can respond to the demand for higher luminance.

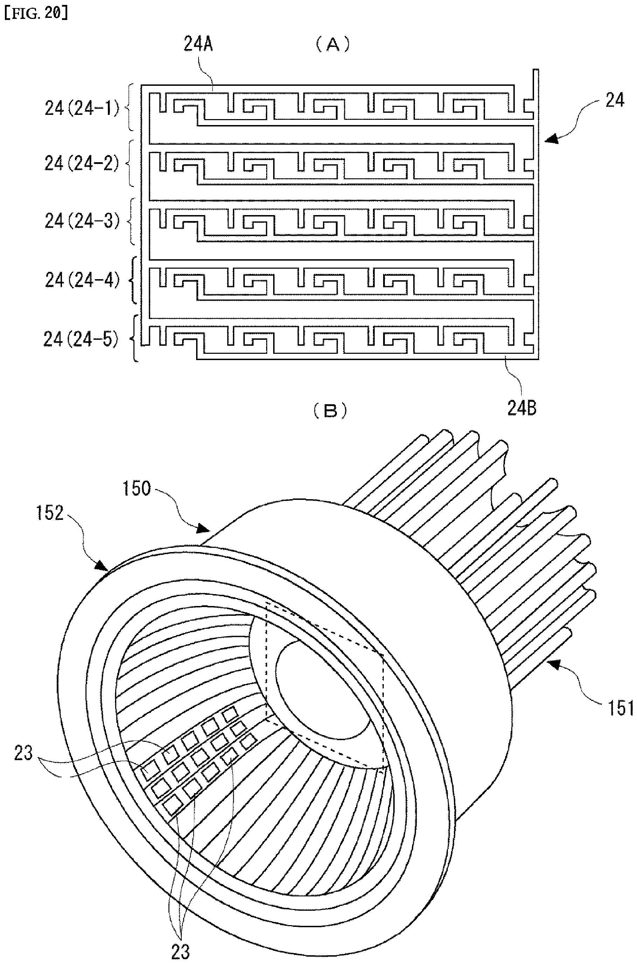

The wiring members 24 may be arranged in parallel in blocks (24-1 to 24-5) as shown in Fig. 20A. The structure shown in Fig. 20A for ease of explanation may include any other numbers of blocks. The wiring members 24 in blocks may be curved along the surface of a reflector 152 as shown in Fig. 20B and mounted in the reflector 152, which is fixed to a heat sink 151 of a downlight 150.

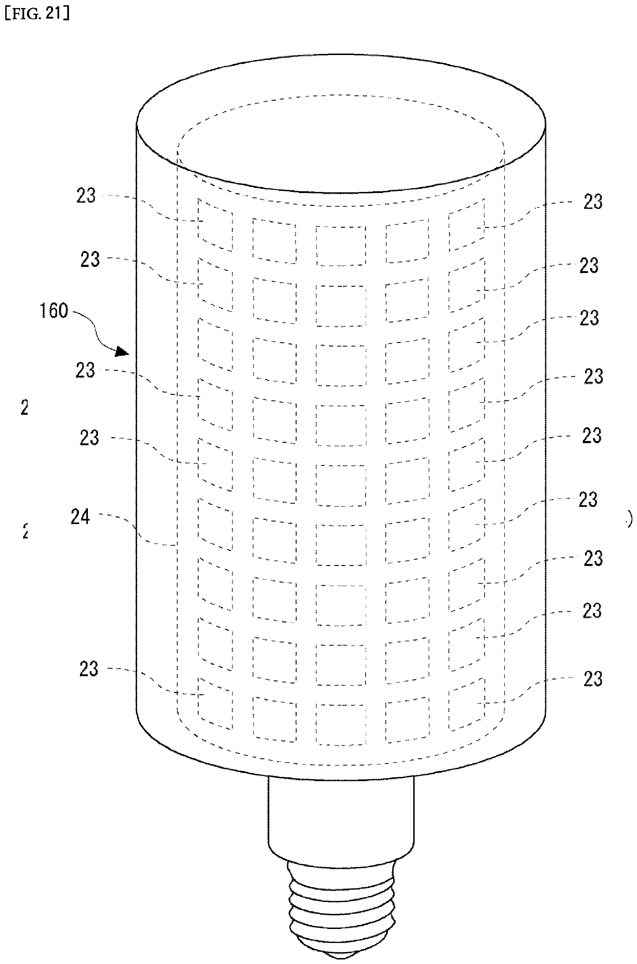

As shown in Fig. 21, the wiring members 24 as a whole may be bent into a cylinder for use in a streetlamp 160, which uniformly emits light in all directions. In this case, the blocks may be arranged along the axis of the cylinder.

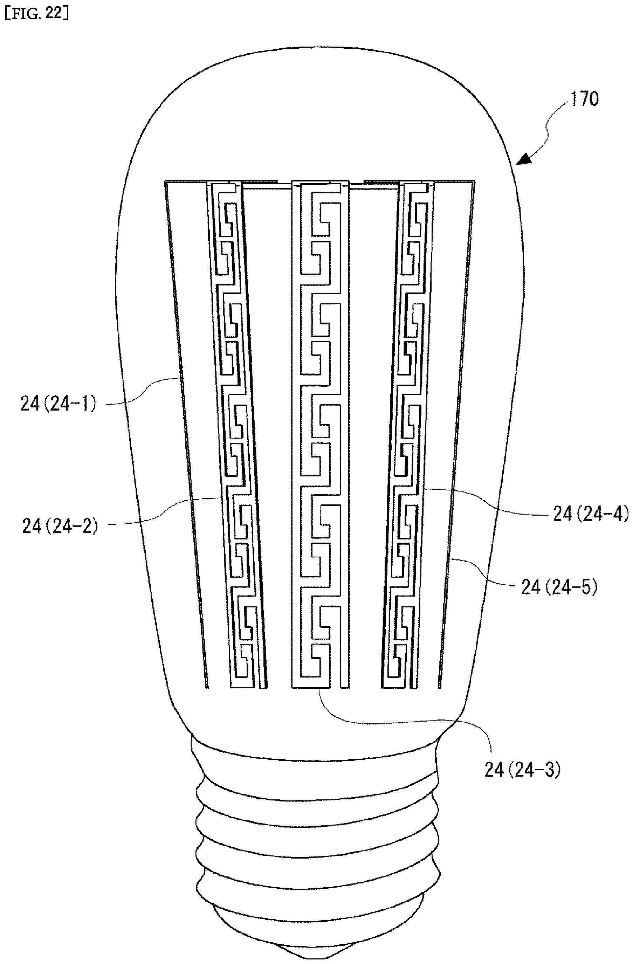

As shown in Fig. 22, the wiring members 24 may be bent in blocks (24-1 to 24-5) for connecting a single point to multiple points for use in a slim bulb LED lamp 170. In this case, the wiring members 24 may integrally include lead wiring member portions in the same manner as the bulb LED lamp 130 shown in Fig. 18B.

The wiring members 24 in the LED lamp 170 shown in Fig. 22 are arranged in eight blocks in one-to-one correspondence with the eight sides of a regular octagon. In the examples described above, the common components, such as the LED chips 23 and the wiring members 24, may not be shown or may be described schematically as appropriate.

Typically, an LED chip having a power consumption of less than 0.1 W per chip (low power) is used as, for example, a backlight for a mobile phone. An LED chip having a power consumption within a range of 0.1 to less than 1.0 W (middle power) may be preferably used as a lighting apparatus for household use. An LED chip having a power consumption of 1 W or more (high power) may also be used as a household lighting apparatus. A middle power LED chip is usually formed from a resin, whereas a high power LED chip is usually formed from a ceramic material, which is expensive. For example, a household lighting apparatus has a rated voltage of 3 V and thus may use a middle power LED chip and may not use a high power LED chip, although a large current cannot be applied to the middle power LED chip compared to a high power LED chip.

For example, the Mid Power High Efficiency 5630 series (LG Corporation) has the power consumption written by the formula below.

$$\text{Power consumption} = 3 \times 0.065 = 0.195 \text{ W} \approx 0.2 \text{ W}$$

The High Power 3535 3 W (LG Corporation) has the power consumption written by the formula below.

$$\text{Power consumption} = 3 \times 0.35 = 1.05 \text{ W} \approx 1 \text{ W}$$

Thus, the middle power LED chip advantageously reduces cost and increases efficiency. The high power LED chip is more reliable, and expects future product development.

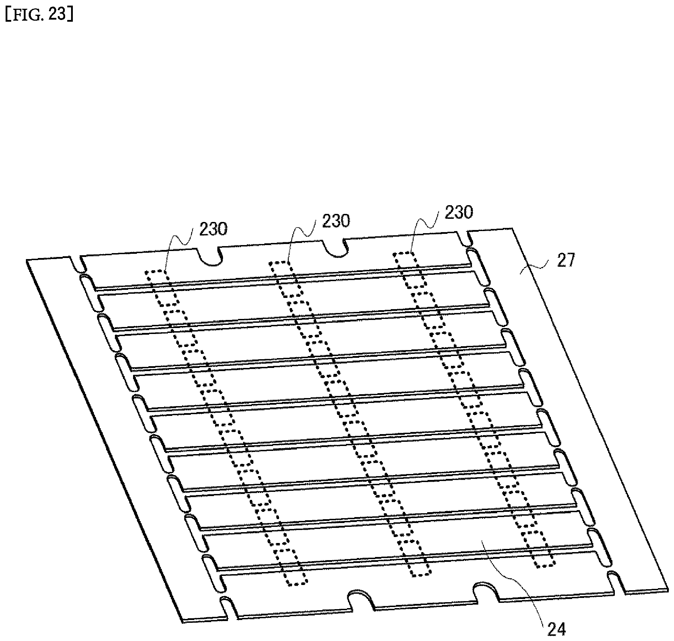

Fig. 23 shows wiring members 24 used in a light-emitting module including two-dimensionally arranged multiple LED chips 23. The LED chips 23 are mounted in parallel in multiple blocks of wiring members 24, which are connected in series. To form the wiring members 24, multiple strips of a conductive metal are arranged in parallel and joined to one another with a bridge 27. In Fig. 23, the dotted lines indicate areas 230 in which the LED chips 23 are to be mounted. Each area 230 includes a connection area for a high-potential wiring member and a connection area for a low-potential wiring member of an LED chip 23 facing each other across a gap between the metal strips. The facing connection areas may be shaped differently to prevent the high-potential wiring member and the low-potential wiring member of the LED chip 23 from being connected to wrong areas when the LED chip 23 is soldered. To simplify the drawing in Fig. 23, only some of the areas 230 are given the reference numeral. As shown in Fig. 23, the LED chips 23, which are mounted across adjacent conductive metal strips, are connected in parallel on the wiring members 24, and the multiple conductive metal strips are connected in series through the LED chips 23. Although the LED chips 23 are in an array of 3 parallel connections by 8 serial connections in Fig. 23, the number of connections is not limited to this. For example, an array of 3 parallel connections by 6 serial connections or an array of 8 parallel connections by 12 serial connections may be used. A different number of LED chips 23 may be connected in parallel in each line. The LED chips 23 connected in series may be staggered, and a different number of LED chips 23 may be connected in series in each line. Conductive metal strips arranged in parallel may have different shapes in each line. The bridge 27 is removed after the LED chips 23 are mounted.

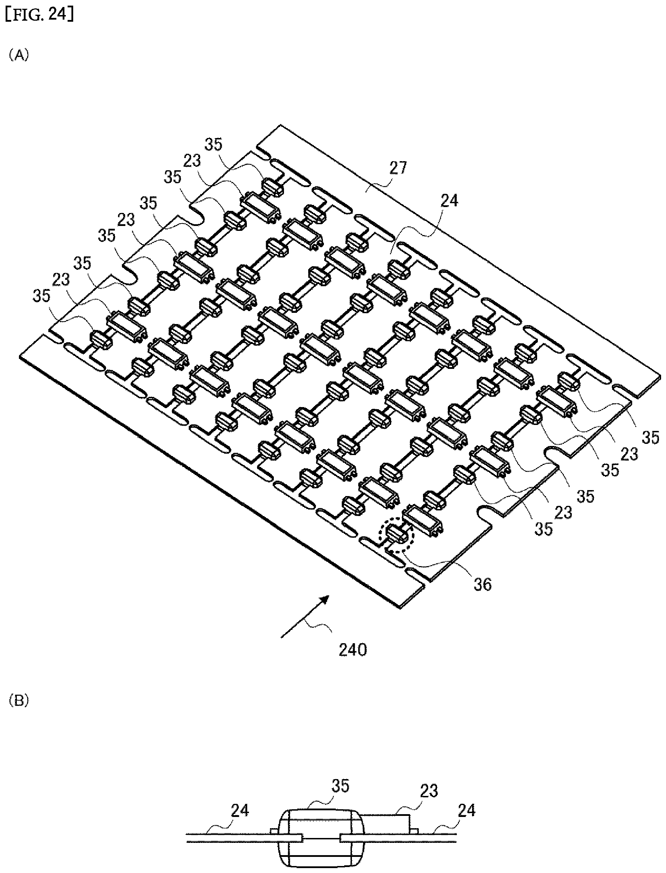

The wiring members 24 elongated in one direction as shown in Figs. 3A and 3B or having a large two-dimensional area as shown in Fig. 20A may receive a force (load) such as torsion when, for example, assembled into an LED lighting apparatus. In the structures shown in Figs. 3A, 3B, and 20A, the high-potential wiring members 24A and the low-potential wiring members 24B are connected only using the electrode terminals (the anode 23A and the cathode 23B) of the multiple LED chips 23 to maintain the shape of a light-emitting module. In such structures, the wiring members 24 deforming under a load may apply the load partially to the LED chips 23, which may then have solder separation at the electrode terminals, deteriorating characteristics, or breakage. To avoid these, the wiring members 24 in Figs. 24A to 28 described below include reinforcements to improve the mechanical strength (durability against bending and torsion) of a light-emitting module.

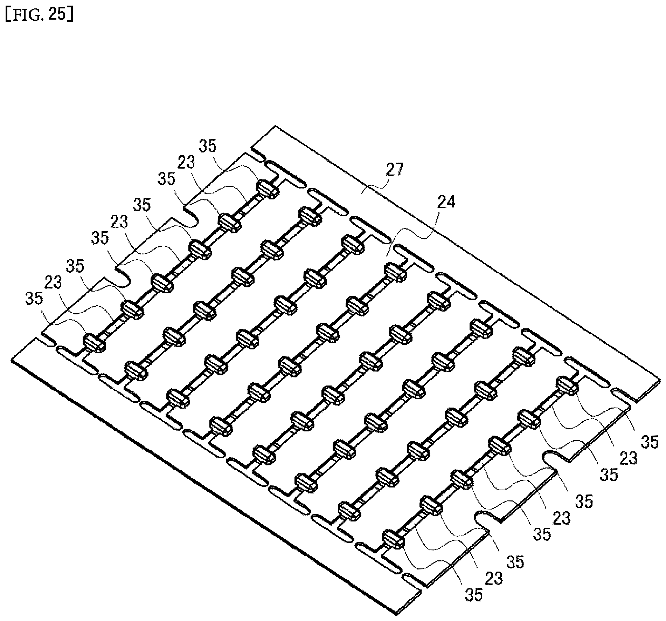

Fig. 24A is a perspective view of a light-emitting module with wiring members 24 shown in Fig. 23 including multiple LED chips 23 and multiple reinforcements 35. Fig. 24B is a side view of an area 36 in Fig. 24A as viewed in the direction indicated by an arrow 240. Fig. 25 is a perspective view of the light-emitting module shown in Fig. 24A showing its rear surface. As shown in Figs. 24A, 24B, and 25, the reinforcements 35 are formed on both sides of the LED chips 23 to join the adjacent wiring members 24. In Fig. 24A and subsequent drawings, only some of the LED chips 23 and the reinforcements 35 are given the reference numerals for purposes of illustration. The reinforcements 35 may not be arranged at equal intervals. The reinforcements 35 may be arranged at multiple positions that do not overlap the mounting positions of the LED chips 23, irrespective of the number of LED chips 23. The number of reinforcements 35 or their positions may be different in each line.

The reinforcements 35 may be formed from a resin with high insulation and good mechanical properties (tensile strength, compressive strength, bending strength, and impact strength). The reinforcements 35 may be formed from resin materials such as polyamide or polycarbonate. The reinforcements 35 may have, for example, a thickness of 1 mm, a width of 2 mm, and a length of 6 mm, or any other dimensions. The reinforcements 35 may be formed on the wiring members 24 by, for example, bonding or outsert molding. The reinforcements 35 may be formed from metal pieces, instead of a resin material, and are bonded to the wiring members 24 in an electrically non-conducting manner using an insulating layer (e.g., an insulating sheet) placed between the reinforcements 35 and the wiring members 24. The reinforcements 35 may be formed from materials other than resin or metal to provide non-conducting structures and to reinforce the wiring members 24.

Although the reinforcements 35 in the example shown in Figs. 24A and 25 are formed on both surfaces of the wiring members 24, the reinforcements 35 may be formed on one surface. However, when the reinforcements 35 formed on both surfaces of the wiring members 24 deform during curing of a resin or due to changes in the surrounding temperature, the deformation can be absorbed by the reinforcements 35 on the two surfaces. The wiring members 24 may be prevented from bending or warping.

The wiring members 24 with the reinforcements 35 reduce the load on the LED chips 23 applied when the wiring members 24 are bent. This prevents the LED chips 23 from having deteriorating performance or breakage, and allows the wiring members 24 to be bent or curved easily during the assembly of an LED lighting apparatus.

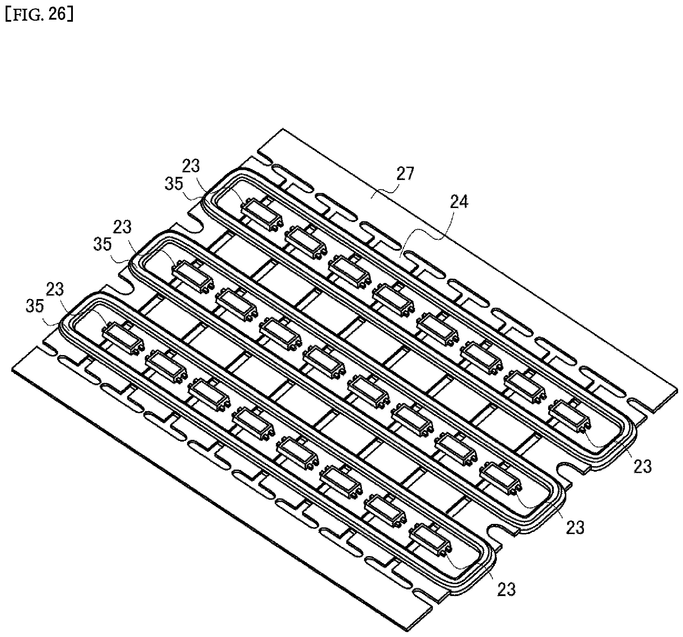

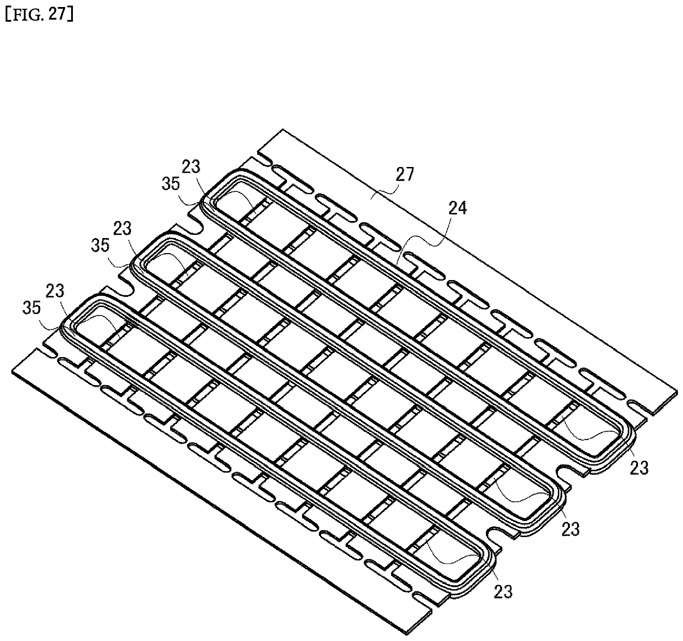

As shown in Figs. 26 and 27, the reinforcements 35 may be continuous portions joining the multiple wiring members 24. When the reinforcements 35 are continuous portions as shown in Figs. 26 and 27, the reinforcements 35 may be perpendicular to the axis along which the wiring members 24 are bent or the direction in which the wiring members 24 are curved.

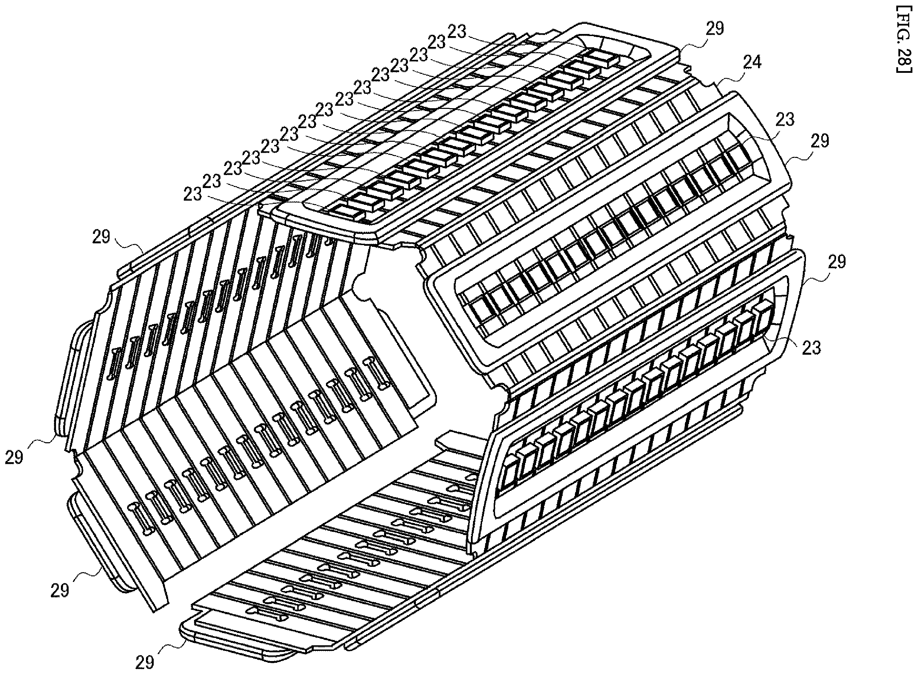

The reinforcements 35 allow the wiring members 24 to be bent or curved easily as described above. This allows, for example, a light-emitting module to be easily formed three-dimensionally for a wide light distribution angle as shown in Fig. 28. Fig. 28 shows an example light-emitting module that is a cylindrical (octagonal prism). The light-emitting module shown in Fig. 28 includes the LED chips 23 in an array of 8 parallel connections by 15 serial connections in the wiring members 24 and the reinforcements 35 on one surface of each wiring member 24. In Fig. 28, the wiring members 24 are bent in the direction of the 8 parallel connections into a substantial cylinder, and then the bridge 27 is removed. The number of connections for the LED chips 23 shown in Fig. 28 is not limited to this example.

Although the LED chips 23 are mounted only on one surface in Figs. 24A to 28, the LED chips 23 may be mounted on the two surfaces of the wiring members 24.

As described above, the LED lighting apparatuses 1, 2, 3, 4 and 5 according to the present invention can have a substrate-less structure eliminating a metal base substrate and an insulating plate, can be lightweight and inexpensive while having a long lifetime, and are usable for any LED lighting apparatus including at least one LED chip as a light source.

**Reference Signs List**

1       LED lighting apparatus
2       LED lighting apparatus
3       LED lighting apparatus
4       LED lighting apparatus
5       LED lighting apparatus
23      LED chip
24      wiring member
25      adhesive
35      reinforcement

**Claims**

1. A light-emitting diode lighting apparatus mountable onto a building material, the apparatus comprising:

    a substrate-less light-emitting module including a thin plate of a conductive wiring member corresponding to a wiring pattern and at least one light-emitting diode directly mounted on the wiring member;
    a translucent cover covering the light-emitting module; and
    a support on which the translucent cover is attached,
    wherein the wiring member is located at the translucent cover or the support.

2. The light-emitting diode lighting apparatus according to claim 1, wherein
    the light-emitting diode lighting apparatus is a straight tube lighting apparatus in which the translucent cover is a long tubular member and the support is a base located on each longitudinal end of the tubular member, and
    the wiring member is located on an inner surface of the tubular member.

3. The light-emitting diode lighting apparatus according to claim 1, further comprising:

    a casing containing a circuit board configured to drive the light-emitting module; and
    a base,
    wherein the light-emitting diode lighting apparatus is a bulb lighting apparatus in which the base, the casing, the support, the light-emitting module, and the translucent cover are located in sequence along an axis of the base, and the translucent cover is a globe covering the support, and
    the wiring member is located at the support adjacent to the globe.

4. The light-emitting diode lighting apparatus according to claim 1, wherein
    the light-emitting diode lighting apparatus is mountable on a ceiling,
    the support includes a base member mountable on the building material, the translucent cover is a shade covering the base member, and
    the wiring member is located on a side of the base member opposite to the building material.

[FIG. 1]

[FIG. 2]

[FIG. 3]

[FIG. 4]

[FIG. 5]

[FIG. 6]

(A)

51

52

3

50

53

60

(B)

62

60

61

24

23

23

23

23

23

63

23

23

23

[FIG. 7]

[FIG. 8]

[FIG. 9]

（A）

71
72
70
73
4

（B）

81
82
4
86
85
83
24
23
23
84
23
23
23

[FIG. 10]

[FIG. 11]

（A）

24

24A — 24B

24C

27

（B）

23

23

24 (24-1)

23

23

24B

24A — 23

24C

23

23

23

23

23

24 (24-2)

23

23

[FIG. 12]

[FIG. 13]

（A）

24（24-1）

24A

24B

23

23

23

23

23

24C

24B

23

23

24（24-2）

23

24A

23

24C

23

（B）

24C

（C）

24C

（D）

24C

（E）24D

（F）

24E

[FIG. 14]

（A）

（B）

（C）

[FIG. 15]

（A）

（B）

（C）

（D）

[FIG. 16]

（A）

24A

24a

24b

24B

（B）

24A

29

29

24B

5(

i4

（C）

24A

24a

23

24b

24B

[FIG. 17]

（A）

24 (24-3)    24 (24-4)

24C

24 (24-2)    100

24 (24-5)

24C

24C

24 (24-1)    24 (24-6)

（B）

24C    110

24 (24-2)

24 (24-1)    24 (24-3)

24 (24-4)

24C

（C）

24 (24-3)    24C    120

24 (24-4)

24 (24-1)

24 (24-2)

24 (24-5)    24 (24-8)

24 (24-6)

24C    24 (24-7)

[FIG. 18]

（A）

24A  23  23  23  23  23  24B

（B）

130

23  23  24

24A  24B

[FIG.19]

（A）

（B）

[FIG. 20]

(A)

(B)

[FIG. 21]

[FIG. 22]

[FIG. 23]

[FIG. 24]

(A)

(B)

[FIG. 25]

[FIG. 26]

[FIG. 27]

[FIG. 28]

## INTERNATIONAL SEARCH REPORT

| International application No. |
| --- |
| PCT/JP2016/089165 |

A.  CLASSIFICATION OF SUBJECT MATTER
*F21V23/00*(2015.01)i, *F21S2/00*(2016.01)i, *F21S8/04*(2006.01)i, *F21V19/00* (2006.01)i, *F21V29/503*(2015.01)i, *F21V29/70*(2015.01)i, *F21Y115/10* (2016.01)n
According to International Patent Classification (IPC) or to both national classification and IPC

B.  FIELDS SEARCHED

Minimum documentation searched (classification system followed by classification symbols)
F21V23/00, F21S2/00, F21S8/04, F21V19/00, F21V29/503, F21V29/70, F21Y115/10

Documentation searched other than minimum documentation to the extent that such documents are included in the fields searched
Jitsuyo Shinan Koho        1922–1996    Jitsuyo Shinan Toroku Koho    1996–2017
Kokai Jitsuyo Shinan Koho  1971–2017    Toroku Jitsuyo Shinan Koho    1994–2017

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
| --- | --- | --- |
| X<br>Y | JP 2013-535764 A  (Koninklijke Philips N.V.),<br>12 September 2013 (12.09.2013),<br>paragraphs [0003] to [0050]; fig. 1 to 8<br>& US 2013/0113002 A1<br>paragraphs [0003] to [0055]; fig. 1 to 8<br>& WO 2012/007899 A1     & EP 2593709 A1<br>& TW 201235609 A        & CN 103026120 A<br>& RU 2013105796 A | 1-2<br>4 |
| Y | JP 2003-59305 A  (ATEX Co., Ltd.),<br>28 February 2003 (28.02.2003),<br>paragraphs [0010] to [0020]; fig. 1<br>& US 2003/0031015 A1<br>paragraphs [0017] to [0027] | 3 |

| ☒  Further documents are listed in the continuation of Box C. | ☐  See patent family annex. |
| --- | --- |

| *    Special categories of cited documents: | "T" later document published after the international filing date or priority date and not in conflict with the application but cited to understand the principle or theory underlying the invention |
| --- | --- |
| "A"  document defining the general state of the art which is not considered   to be of particular relevance | |
| "E"  earlier application or patent but published on or after the international filing date | "X" document of particular relevance; the claimed invention cannot be considered novel or cannot be considered to involve an inventive step when the document is taken alone |
| "L"  document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O"  document referring to an oral disclosure, use, exhibition or other means | |
| "P"  document published prior to the international filing date but later than the priority date claimed | "&" document member of the same patent family |

| Date of the actual completion of the international search<br>02 March 2017 (02.03.17) | Date of mailing of the international search report<br>14 March 2017 (14.03.17) |
| --- | --- |
| Name and mailing address of the ISA/<br>Japan Patent Office<br>3-4-3,Kasumigaseki,Chiyoda-ku,<br>Tokyo 100-8915,Japan | Authorized officer<br><br>Telephone No. |

Form PCT/ISA/210 (second sheet) (January 2015)

**INTERNATIONAL SEARCH REPORT**

| International application No. |
| --- |
| PCT/JP2016/089165 |

C (Continuation). DOCUMENTS CONSIDERED TO BE RELEVANT

| Category* | Citation of document, with indication, where appropriate, of the relevant passages | Relevant to claim No. |
| --- | --- | --- |
| Y | JP 3075689 U (Hakuyo Denkyu Co., Ltd.), 27 February 2001 (27.02.2001), paragraphs [0009] to [0012]; fig. 1 to 3 (Family:none) | 3 |
| Y | JP 2015-173125 A (Toshiba Lighting & Technology Corp.), 01 October 2015 (01.10.2015), paragraphs [0014] to [0110]; fig. 1 to 7 (Family: none) | 4 |

Form PCT/ISA/210 (continuation of second sheet) (January 2015)

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007059930 A